# FASCICULE DE BREVET EUROPEEN

(11) **EP 1 184 966 B1**
(45) Date de publication et mention de la délivrance du brevet: **05.04.2006**
(21) Numéro de dépôt: 01402209.9
(22) Date de dépôt: 22.08.2001
(51) Int. Cl.: H03B 5/12, H03K 3/80

(54) **Générateur pulsé à haute fréquence et à haute tension, et alimentation électrique équipée d'un tel générateur**
Hochspannungsimpulsgenerator und mit solchem Generator ausgerüstete elektrische Versorgungseinrichtung
High-voltage pulse generator and electrical power supply equipped with such a generator

(30) Priorité: 24.08.2000 FR 0010897
(43) Date de publication de la demande: 06.03.2002
(73) Titulaire: COMMISSARIAT A L'ENERGIE ATOMIQUE, 75752 Paris Cédex 15 (FR)
(72) Inventeur: Chatroux, Daniel, 26200 Montélimar (FR); Lausenaz, Yvan, 38210 Tullins (FR); Villard, Jean-François, 91120 Palaiseau (FR)
(74) Mandataire: Weber, Etienne Nicolas

(56) Documents cités:
- DE-A- 2 602 794
- DE-A- 4 119 738
- US-A- 3 849 741

## Description

### Domaine technique

La présente invention concerne un générateur pulsé à haute tension et à haute fréquence. Elle concerne également une alimentation électrique équipée d'un tel générateur.

On entend par générateur pulsé un générateur capable de fournir des impulsions de tension et en particulier des impulsions oscillatoires. Ces impulsions sont, dans le cadre de l'invention, des impulsions sous la forme d'un signal à haute fréquence, délivrées sous haute tension, pendant des durées courtes, et avec une fréquence de répétition élevée. De façon plus précise l'invention vise à fournir, par exemple, des impulsions à plusieurs centaines de mégahertz sous plusieurs centaines de volt, dont la durée est de l'ordre de la centaine de nanosecondes et dont la fréquence de répétition est de plusieurs dizaines de kilohertz.

L'invention trouve des applications notamment pour l'alimentation électrique et la commande de cristaux électro-optiques, dans des dispositifs tels que des modulateurs ou des commutateurs optiques.

### Etat de la technique antérieure

Les générateurs pulsés connus, capables de fournir des signaux oscillant à des fréquences supérieures à 100MHz et présentant une amplitude supérieure à 100 Volt associent généralement un oscillateur à basse tension et un amplificateur résonnant de haute tension.

Les oscillateurs à basse tension sont construits, par exemple, autour d'un circuit résonnant incluant une capacité et une inductance, ou éventuellement autour d'un circuit à quartz. Ils délivrent un signal oscillant à haute fréquence mais dont l'amplitude est faible. On considère ici qu'une faible amplitude de signal est une amplitude en tension inférieure à 100 Volt.

Le circuit résonnant des oscillateurs à basse tension peut être associé à un amplificateur à transistors fonctionnant également à basse tension. L'amplificateur est par exemple du type à transistors bipolaires ou du type à transistors à effet de champ.

Pour obtenir des signaux de forte amplitude, le signal issu de l'oscillateur à basse tension est délivré à un amplificateur résonnant de haute tension. Un tel amplificateur, capable de délivrer des signaux avec une amplitude de plusieurs centaines de volts, comprend généralement une cavité d'amplification.

Une première antenne placée dans la cavité est reliée à l'amplificateur de basse tension et émet dans la cavité un champ électromagnétique pulsé de haute fréquence. Ce champ est reçu par une charge également placée dans la cavité et qui forme en quelque sorte une antenne de réception. La charge est, par exemple, un cristal électro-optique.

Lorsque la fréquence du signal électrique appliqué à la première antenne est voisine de la fréquence de résonance de la cavité, le champ électromagnétique dans la cavité est amplifié. Ainsi, la charge voit apparaître à ses bornes une tension pulsée oscillant à haute fréquence et dont l'amplitude est supérieure à celle du signal appliqué à la première antenne. Dans un tel générateur, la fréquence de fonctionnement est par conséquent dictée par la forme et les dimensions de la cavité, qui fixent sa fréquence de résonance.

Le générateur décrit présente un certain nombre de difficultés et de limitations qui sont exposées ci-après.

Une première difficulté tient à la lenteur de démarrage du générateur. Le champ électrique produit dans la cavité est initialement de faible amplitude et doit osciller un certain nombre de fois avant que le signal de sortie délivré aux bornes de la charge ne présente l'amplitude souhaitée. La lenteur du démarrage pose alors des problèmes de dissipation thermique. En effet, l'énergie transmise pendant le démarrage est dissipée dans la charge lors de chaque nouvelle impulsion, sans que le signal de sortie utile ne soit disponible.

Une deuxième difficulté apparaît pour contrôler la phase du signal reçu par la charge. Ce signal est tributaire non seulement de la gigue (jitter) de l'oscillateur de basse tension mais aussi de celle de la cavité. La gigue du signal de sortie en haute tension est encore accrue par la lenteur du démarrage évoquée précédemment. Or, il s'avère que pour des applications requérant des signaux oscillant à haute fréquence, et en particulier à des fréquences de plusieurs centaines de mégahertz, une gigue inférieure à une nanoseconde est souvent indispensable.

Une troisième difficulté est liée au fait que la fréquence du signal fourni ne peut pas être modifiée facilement. Comme indiqué précédemment, la fréquence du signal de sortie est fixée par la fréquence de résonance de la cavité, c'est à dire par sa forme et ses dimensions. Il est par conséquent impossible d'obtenir sur une charge unique, placée dans la cavité, un signal électrique qui serait la composition de plusieurs fréquences d'oscillation. A l'heure actuelle une commande à fréquences multiples d'un système optique à cristaux électro-optique ne peut avoir lieu qu'au moyen d'un couplage optique : une pluralité de cristaux sont connectés optiquement en série et sont chacun alimentés par une cavité différente, fonctionnant respectivement selon un mode mono- fréquence. Des contraintes importantes apparaissent pour le transport des faisceaux de lumière, pour l'alignement des cristaux ou pour le réglage des déphasages entre les différentes fréquences d'oscillation des différentes cavités.

D'autres difficultés sont liées à la taille et au poids des générateurs. Ceux-ci sont principalement imposés par la taille et le poids des cavités. Enfin, la mise en oeuvre des dispositifs décrits ci-dessus requiert des réglages mécaniques délicats avant leur mise en fonctionnement.

Des Informations supplémentaires concernant l'état de la technique montrent à l'homme du métier d'autres exemples de générateurs de signaux pulsés haute fréquence et haute tension ainsi que des exemples d'implémentation de circuits d'oscillateurs. Ces informations sont contenues dans les documents DE 4 1179 738 A1 ainsi que VS 4 429 694

### Exposé de l'invention

L'invention a pour but de proposer un générateur pulsé ne présentant pas les limitations et difficultés mentionnées ci -dessus.

Un but est en particulier de proposer un générateur capable de délivrer des signaux oscillants pulsés de haute fréquence, à haute tension et avec une fréquence de répétition élevée, la fréquence de répétition étant comprise ici comme la fréquence de renouvellement des impulsions oscillantes.

Un autre but est de proposer un générateur de faible poids et présentant un encombrement réduit.

Un but supplémentaire est de proposer un générateur avec une faible gigue, de façon à pouvoir contrôler avec plus de précision la phase du signal pulsé.

Un but est encore de proposer un générateur pulsé ne présentant qu'un retard au démarrage extrêmement faible comparativement aux générateurs connus.

Enfin, un but de l'invention est de proposer une alimentation électrique équipée d'un tel générateur.

Pour atteindre ces buts, l'invention a plus précisément pour objet un générateur pulsé comprenant :
- au moins un transistor de commutation pour fournir des impulsions de sortie à partir d'une source d'alimentation de haute tension,
- un premier et un deuxième circuits oscillants connectés à une borne de commande du transistor pour piloter le transistor selon un régime de commutation oscillant, et
- des moyens d'amorçage de l'oscillation comprenant un générateur d'impulsions d'amorçage, relié à la borne de commande du transistor et des moyens inductifs d'excitation relient le transistor à une borne de haute tension de la source de haute tension.

Le générateur pulsé peut comporter-un seul ou plusieurs transistors associés, capables de commuter des tensions élevées. Il s'agit par exemple d'un transistor MOSFET (Transistor à effet de champ de type Métal Oxyde Semi-Conducteur) capable de commuter des tensions de l'ordre de 500 Volt. Bien que plusieurs transistors puissent être utilisés, la description qui suit se réfère, pour des raisons de simplification, à un unique transistor. Celui-ci peut être compris, le cas échéant, comme étant un transistor résultant de l'association de plusieurs transistors individuels.

Le générateur d'impulsions d'amorçage permet de provoquer de façon extrêmement rapide une première commutation du transistor et donc de réduire au minimum d'éventuelles dissipations thermiques dans une charge qui serait reliée au générateur.

Selon l'invention les moyens d'amorçage de l'oscillation, décrite plus en détail dans la suite du texte, ceux-ci comportent en plus du générateur d'impulsions, un accumulateur d'énergie, par exemple sous la forme d'une inductance.

Le générateur d'impulsions d'amorçage permet de faire passer brutalement le transistor d'un état de conduction à un état bloqué. L'inductance, reliée au transistor, permet alors de fournir, en réponse au blocage du transistor, une surtension transitoire suffisante pour amorcer l'oscillation. L'oscillation est amorcée dans le premier et le deuxième circuits oscillants qui, à leur tour, commandent le transistor.

Grâce aux moyens d'amorçage de l'oscillation l'instant de déclenchement des oscillations peut être maîtrisé avec une très grande précision de sorte que la gigue du signal de sortie est très faible. Une gigue inférieure à une nanoseconde peut facilement être obtenue avec un générateur conforme à l'invention. De plus, une oscillation avec un amplitude nominale peut être obtenue immédiatement.

Selon l'invention, les deux circuits oscillants sont reliés à une borne de commande du transistor, en l'occurrence sa grille, pour commander l'état de commutation de ce dernier. Un premier circuit oscillant peut être connecté par exemple entre la source et la grille du transistor tandis que le deuxième circuit oscillant est connecté entre le drain et la grille du transistor. Dans un tel schéma, l'un des circuits oscillants sert essentiellement à fixer la fréquence des oscillations tandis que le second circuit oscillant sert essentiellement à transférer de l'énergie de la source de haute tension vers la grille. Cette réalisation particulière est décrite également dans la suite du texte.

Un fonctionnement optimal du générateur est obtenu lorsque le premier et le deuxième circuits oscillants sont accordés sur une même fréquence de résonance. Cette fréquence, qui détermine également la fréquence des impulsions de sortie du générateur, peut être ajustée très facilement par le choix ou le réglage des composants des circuits oscillants. En particulier, lorsque les circuits oscillants comportent une capacité et une inductance, le simple remplacement d'un condensateur ou d'un enroulement permet de régler la fréquence. Les condensateurs ou les enroulements utilisés peuvent aussi être des composants à valeurs ajustables.

Selon un autre aspect de l'invention, le générateur peut comporter une capacité de sortie qui relie le transistor à une borne de sortie pour diriger les impulsions vers cette borne. Une telle capacité, réalisée, par exemple par un condensateur, permet de filtrer les composantes continues du signal et permet de conférer au générateur une impédance de sortie élevée.

La caractéristique d'une impédance élevée est particulièrement avantageuse dans la mesure où elle autorise la connexion à une même charge, d'une pluralité de générateurs fonctionnant indépendamment les uns des autres. Ainsi, il est possible d'appliquer à la charge un signal électrique multi-fréquence qui est la composition de plusieurs signaux de fréquences différentes.

La possibilité d'alimenter un cristal unique avec un signal multi-fréquence supprime les problèmes liés à l'installation d'une pluralité de cristaux sur un même trajet de lumière.

Le décalage de phase entre les différents signaux appliqués à un même cristal peut par ailleurs être ajusté très simplement en décalant de manière appropriée les impulsions d'amorçage de l'oscillation des différents générateurs.

L'invention concerne également un alimentation électrique équipée d'un générateur tel que décrit.

D'autres caractéristiques et avantages de l'invention ressortiront de la description qui va suivre en référence à la figure unique du dessin annexé. Cette description est donnée à titre purement illustratif et non limitatif.

### Description détaillée de modes particuliers de mise en oeuvre de l'invention.

La figure unique est un schéma de câblage simplifié d'un circuit d'alimentation électrique d'une charge, équipé d'un générateur pulsé conforme à l'invention.

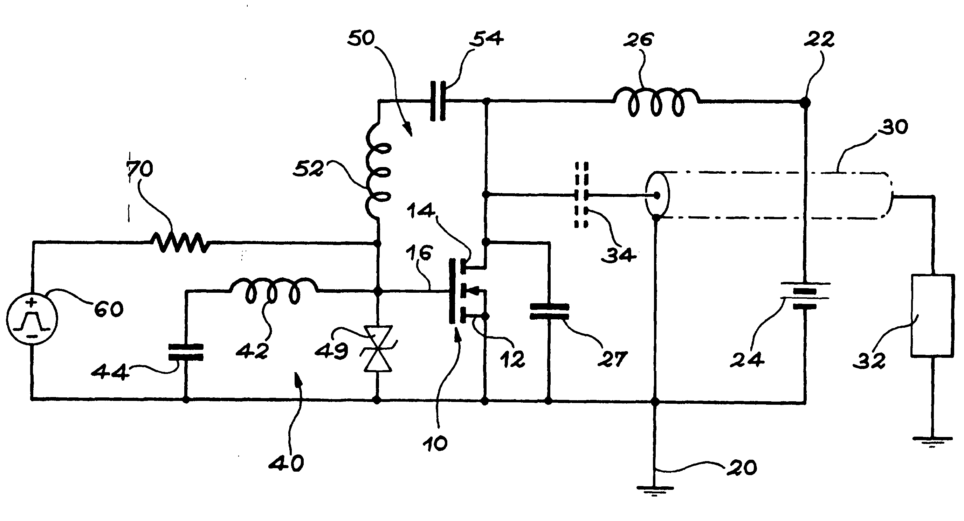

Le coeur du générateur de la figure 1 est un transistor MOSFET de puissance 10 avec une source 12, un drain 14 et une grille 16. La source 12 est connectée à une borne de masse 20 et le drain 14 est relié à une borne de haute tension 22 d'une source de haute tension 24. Le drain est plus précisément relié à la borne de haute tension 22 par une liaison inductive formée, dans l'exemple de la figure, par un enroulement 26. Cet enroulement est encore désigné par enroulement d'excitation dans la suite du texte.

Un câble coaxial 30, qui forme ici la sortie de l'alimentation, présente des armatures connectées respectivement à la source et au drain du transistor. Il permet de transmettre à une charge 32 les impulsions électriques fournies par l'alimentation. Le câble coaxial, avec un impédance adaptée (50Ω, par exemple), permet en particulier de relier l'alimentation à une charge électrique 32 se trouvant à distance.

La liaison entre l'alimentation et la charge électrique 32 peut aussi être une liaison directe courte (par simple fil) ou éventuellement à travers un circuit résonnant , par exemple de type LC (inductance-capacité) accordé sur la fréquence des oscillations du signal délivré par l'alimentation. Le signal oscillant -peut alors être amplifié une nouvelle fois avant d'être appliqué à la charge.

On peut observer par ailleurs qu'un condensateur de liaison 34 est prévu entre le drain 14 du transistor 10 et le câble coaxial 30. Le condensateur 34 a essentiellement un rôle de filtre pour éliminer les composantes de basse fréquence et une composante continue du signal délivré par l'alimentation. Il confère également à la sortie une impédance élevée. La valeur du condensateur est choisie, par exemple, pour ne laisser passer que les fréquences supérieures à 10 MHz.

Le générateur pulsé comporte deux circuits oscillants 40 et 50. Le premier circuit oscillant 40, désigné par circuit oscillant principal, est formé par un enroulement 42 et un condensateur 44 connectés en série, et dans l'ordre indiqué, entre la grille 16 du transistor 10 et sa source 12. Il fixe pour l'essentiel la fréquence d'oscillation du générateur.

Un dispositif d'écrêtage 49 est connecté par ailleurs en parallèle entre la grille et la source du transistor pour limiter la tension grille-source à une valeur maximum déterminée par les caractéristiques du transistor. Le dispositif d'écrêtage est, par exemple, une diode transil bidirectionnelle.

Un deuxième circuit oscillant 50, désigné par circuit de transfert d'énergie, présente une fréquence de résonance accordée sur celle du circuit oscillant principal 40. Le deuxième circuit oscillant 50 comporte un enroulement 52 et un condensateur 54 connectés dans cet ordre entre la grille 16 du transistor et le drain 14.

Pour terminer la description du schéma de câblage on peut mentionner un condensateur 27 de stockage d'énergie connecté entre la source 12 et le drain 14 du transistor 10 et un générateur 60 d'impulsions d'amorçage connecté entre la source 12 et la grille 16 du transistor 10, en série avec une résistance 70 de maintien du potentiel de grille.

Il convient d'examiner à présent le fonctionnement d'une alimentation conforme au schéma décrit.

Le générateur 60 d'impulsions d'amorçage est un générateur capable de délivrer périodiquement des impulsions de tension de courte durée, typiquement de l'ordre de 100 ns, formant des impulsions d'amorçage et de synchronisation. La fréquence des impulsions d'amorçage correspond à la fréquence de répétition des impulsions oscillantes que doit délivrer le générateur pulsé.

A un instant initial précédant une première impulsion d'amorçage, la tension délivrée par le générateur d'impulsions 60 est nulle. Le transistor 10 se trouve alors dans un état bloqué (off) et la tension de sortie de l'alimentation est nulle.

Lors d'une première impulsion d'amorçage, la tension délivrée par le générateur d'impulsions d'amorçage passe à un état haut et est appliquée à la grille du transistor 10 par l'intermédiaire de la résistance 70, pour mettre le transistor dans un état de conduction (on). Dans cet état, un courant est établi à travers le transistor et à travers l'enroulement d'excitation 26, en série avec le transistor entre les bornes de la source de haute tension 24.

A la fin de la première impulsion du générateur d'impulsion d'amorçage, la tension de ce générateur retombe à la valeur nulle. La tension de la grille du transistor ne suit cependant pas immédiatement l'évolution de cette tension. En effet, une capacité de grille du transistor (interne) se décharge lentement à travers la résistance de maintien 70.

Lors de cette décharge, dès que la tension grille-source du transistor chute sous une tension de seuil de déclenchement du transistor, le transistor repasse dans l'état bloqué.

Le courant qui circulait à travers l'enroulement d'excitation 26 est donc brutalement interrompu. Ceci provoque une variation rapide et forte de la tension aux bornes de l'enroulement. Cette variation de tension excite alors les circuits oscillants 40 et 50 qui sont de préférence accordés sur une même fréquence de résonance.

A cet instant, la tension de grille du transistor est encore proche du seuil de conduction en raison de la décharge lente à travers la résistance de maintien 70. Les oscillations des circuits oscillants 40, 50 s'appliquent à la grille du transistor et sont donc amplifiées par celui-ci. Il en résulte que la tension drain-source oscille à la fréquence de résonance fixée par les circuits oscillants.

L'énergie fournie par la source de haute tension 24, de même que celle stockée dans le condensateur 27 connecté entre la source et le drain, de même que celle de l'enroulement 26, permettent d'obtenir des oscillations---de la tension drain-source de forte amplitude. Ces oscillations, de haute tension et de haute fréquence, sont transmises directement en sortie.

L'oscillation de la tension drain-source du transistor 10, est directement appliquée aux circuits résonnants 40 et 50 respectivement connectés à la source 12 et au drain 14. Les oscillations sont ainsi entretenues, au moins aussi longtemps que la tension grille-source demeure voisine du seuil de conduction du transistor. La valeur de la résistance de maintien 70, à travers laquelle se décharge la capacité grille-source interne du transistor, permet ainsi de fixer la durée de la période d'oscillations, c'est à dire la durée des impulsions.

La fréquence des oscillations est fixée par les valeurs des capacités et inductances des circuits résonnants, tandis que leur amplitude est fixée par la valeur de la tension de la source de haute tension 24 et par la capacité du condensateur 27 connecté entre le drain et la source du transistor.

Selon un exemple de réalisation donné à titre d'illustration, il est possible de générer des impulsions d'une durée de 70 ns, à une fréquence de 250 MHz avec des composants dont les valeurs sont les suivantes :
C (54) = 100 pF
L (52) = 10 nH
C (27) = 47 pF
C (44) = réglable de 2 à 18 pF
L (42) = 70 nH
C (34) = réglable de 2 à 18 pF
R (70) = 100 Ω

La fréquence de récurrence des impulsions est celle du générateur (60), soit 20 KHz dans cet exemple de réalisation particulier.

Lorsque la tension grille-source devient sensiblement inférieure à la tension de seuil de conduction, le transistor se bloque complètement et le phénomène oscillatoire prend fin jusqu'à une prochaine impulsion d'amorçage provenant du générateur 60. Le signal de sortie passe à zéro volt.

Bien que la figure ne représente qu'une seule alimentation pour la charge 32, il est possible d'y connecter facilement plusieurs alimentations distinctes dès lors que cette connexion n'implique aucun réglage mécanique.

La connexion de plusieurs alimentations est facilitée lorsque celles-ci présentent, grâce au condensateur de liaison 34, une impédance de sortie élevée.

## Revendications

1. Générateur pulsé comprenant au moins un transistor de commutation (10) pour fournir des impulsions de sortie à partir d'une source d'alimentation de haute tension (24), **caractérisé en ce qu'**il comprend :
- un premier et un deuxième circuits oscillants (40, 50) connectés à une borne de commande (16) du transistor (10) pour piloter le transistor selon un régime de commutation oscillant, et
- des moyens d'amorçage de l'oscillation comprenant un générateur (60) d'impulsions d'amorçage relié à la borne de commande (16) du transistor (10) et des moyens inductifs (26) d'excitation reliant le transistor à une borne de haute tension (22) de la source de haute tension (24).

2. Générateur selon la revendication 1, comprenant au moins un transistor (10) à effet de,champ avec une source (12), un drain (14), et une grille (16) formant la borne de commande, dans lequel le premier circuit oscillant (40) est connecté entre la source et la grille et dans lequel le deuxième circuit oscillant (50) est connecté entre le drain et la grille.

3. Générateur selon la revendication 1 ou 2, dans lequel le premier et le deuxième circuits oscillants sont accordés sur une même fréquence de résonance.

4. Générateur selon la revendication 2, comprenant un condensateur (27) de stockage d'énergie connecté entre la source et le drain du transistor.

5. Générateur selon la revendication 2, dans lequel la source (12) est reliée à une borne de masse et dans lequel le drain (14) est relié à travers les moyens inductifs d'excitation à la borne de haute tension (22).

6. Générateur selon la revendication 2, comprenant des moyens d'écrêtage (49) connectés à la grille du transistor.

7. Générateur selon la revendication 2, comprenant une résistance (70) de maintien de potentiel connectée à la grille du transistor.

8. Dispositif d'alimentation électrique d'une charge à haute tension et à haute fréquence comprenant une source de haute tension et au moins un générateur pulsé conforme à l'une quelconque des revendications précédentes.

9. Dispositif d'alimentation selon la revendication 8, connecté à une charge, et comprenant une liaison (30) de type coaxiale entre le générateur pulsé et la charge.

10. Dispositif d'alimentation selon la revendication 8, connecté à une charge, et comprenant un condensateur de liaison (34) entre le générateur pulsé et la charge.

## Patentansprüche

1. Impulsgenerator, wenigstens einen Schalttransistor (10) umfassend, um mit Hilfe einer Hochspannungsversorgungsquelle (24) Ausgangsimpulse zu liefem:
**dadurch gekennzeichnet, dass** er umfasst:
- einen ersten und zweiten Schwingkreis (40, 50), verbunden mit einem Steuerungsanschluss (16) des Transistors (10), um den Transistor entsprechend einem schwingenden Schaltbetrieb zu steuern, und
- Schwingungsausfösungseinrichtungen, einen Auslösungsimpulsgenerator (60) umfassend, verbunden mit dem Steuerungsanschluss (16) des Transistors (10) und mit induktiven Anregungseinrichtungen (26), die den Transistor mit einem Hochspannungsanschluss (22) der Hochspannungsquelle (24) verbinden.

2. Generator nach Anschluss 1, wenigstens einen Feldeffekttransistor (10) mit einer Source (12), einem Drain (14) und einem den Steuerungsanschluss bildenden Gate (16) umfassend, bei dem der erste Schwingkreis (40) zwischen der Source und dem Gate geschaltet ist, und der zweite Schwingkreis (50) zwischen dem Drain und dem Gate geschaltet ist.

3. Generator nach Anspruch 1 oder 2, bei dem der erste und der zweite Schaltkreis auf eine selbe Resonanzfrequenz abgestimmt sind.

4. Generator nach Anspruch 2, einen zwischen der Source und dem Drain des Transistors geschalteten Energiespeicherungskondensator (27) umfassend.

5. Generator nach Anspruch 2, bei dem die Source (12) mit einem Masse-Anschluss verbunden ist, und bei dem der Drain (14) durch induktive Anregungseinrichtungen hindurch mit dem Hochspannungsanschluss (22) verbunden ist.

6. Generator nach Anspruch 2, mit dem Gate des Transistors verbundene Spitzenbeschneidungseinrichtungen (49) umfassend.

7. Generator nach Anspruch 2, einen mit dem Gate des Transistors verbundenen Potentialaufrechterhaltungs-Widerstand (70) umfassend.

8. Elektrische Hochspannung- und Hochfrequenzversorgungsvorrichtung einer Last, eine Hochspannungsquelle und wenigstens einen Impulsgenerator nach einem der vorhergehenden Ansprüche umfassend.

9. Versorgungsvorrichtung nach Anspruch 8, angeschlossen an eine Last, und eine Verbindung (30) des koaxialen Typs zwischen dem Impulsgenerator und der Last umfassend.

10. Versorgungsvorrichtung nach Anspruch 8, angeschlossen an eine Last, und einen Verbindungskondensator (34) zwischen dem Impulsgenerator und der Last umfassend.

## Claims

1. Pulse generator comprising at least one switching transistor (10) for providing output pulses on the basis of a high-voltage power supply source (24), **characterized in that** it comprises:
- a first and a second oscillating circuit (40, 50) connected to a control terminal (16) of the transistor (10) so as to drive the transistor according to an oscillating switching regime, and
- means of start-up of the oscillation comprising a start-up pulse generator (60) linked to the control terminal (16) of the transistor (10) and inductive means (26) of excitation linking the transistor to a high-voltage terminal (22) of the high-voltage source (24).

2. Generator according to Claim 1, comprising at least one field-effect transistor (10) with a source (12), a drain (14), and a gate (16) forming the control terminal, in which the first oscillating circuit (40) is connected between the source and the gate and in which the second oscillating circuit (50) is connected between the drain and the gate.

3. Generator according to Claim 1 or 2, in which the first and the second oscillating circuits are tuned to one and the same resonant frequency.

4. Generator according to Claim 2, comprising an energy storage capacitor (27) connected between the source and the drain of the transistor.

5. Generator according to Claim 2, in which the source (12) is linked to an earth terminal and in which the drain (14) is linked across the inductive means of excitation to the high-voltage terminal (22).

6. Generator according to Claim 2, comprising clamping means (49) connected to the -gate of the transistor.

7. Generator according to Claim 2, comprising a potential-holding resistor (70) connected to the gate of the transistor.

8. Device for the electrical power supply of a load at high voltage and at high frequency comprising a high-voltage source and at least one pulse generator in accordance with any one of the preceding claims.

9. Power supply device according to Claim 8, connected to a load, and comprising a link (30) of coaxial type between the pulse generator and the load.

10. Power supply device according to Claim 8, connected to a load, and comprising a linking capacitor (34) between the pulse generator and the load.
